# EUROPEAN PATENT SPECIFICATION

(11) **EP 4 020 502 B1**
(45) Date of publication and mention of the grant of the patent: **01.11.2023**
(21) Application number: 20900882.0
(22) Date of filing: 12.11.2020
(51) Int. Cl.: H01B 5/14, H01B 13/00, C03C 17/36

(54) **ELECTRONIC DEVICE COMPRISING A CONDUCTIVE ELECTRODE**
ELEKTRONISCHE VORRICHTUNG BEINHALTEND EINE LEITFÄHIGE ELEKTRODE
DISPOSITIF ÉLECTRONIQUE COMPRENANT ÉLECTRODE CONDUCTRICE

(30) Priority: 20.12.2019 CN 201911329101
(43) Date of publication of application: 29.06.2022
(73) Proprietor: Honor Device Co., Ltd., Shenzhen, Guangdong 518040 (CN)
(72) Inventor: SHANG, Panju, Shenzhen, Guangdong 518040 (CN); SI, Hui, Shenzhen, Guangdong 518040 (CN); YOU, Jinsong, Shenzhen, Guangdong 518040 (CN); ZHENG, Hong, Shenzhen, Guangdong 518040 (CN); WU, Bin, Shenzhen, Guangdong 518040 (CN)
(74) Representative: Gill Jennings & Every LLP
(86) International application number: PCT/CN2020/128329
(87) International publication number: WO 2021/120932

(56) References cited:
- WO-A1-00/37380
- CN-A- 102 543 266
- CN-A- 104 064 257
- CN-A- 104 882 192
- CN-A- 104 947 140
- CN-A- 104 979 037
- US-A- 5 110 637
- US-A1- 2017 012 147

## Description

### TECHNICAL FIELD

This application relates to the field of conductive electrode and electronic device technologies, and in particular, to a conductive electrode, a preparation method thereof, and an electronic device.

### BACKGROUND

In recent years, electronic devices such as mobile phones, tablet computers and other consumer electronics have become indispensable tools in people's daily life. Such electronic products not only meet people's conventional communication requirements, but also need to meet requirements for entertainment, photographing, payment, and the like. Therefore, in machining and manufacturing of mobile phone electronic products, requirements are raised on miniaturization (portability), high integration (reducing a volume and a thickness), high complexity (integration of a plurality of different functional modules), high reliability (long-term operation), and the like. As an important module for function innovation of a mobile phone, a projector is also integrated into the mobile phone. Its transparent conductive electrode (such as an indium tin oxide electrode, ITO electrode for short) has a small size (usually 0.1-0.2 mm²) and is required to have high reliability (an electrical connection point needs to withstand high temperature and high humidity, high-speed impact and other scenarios).

US 5 110 637 A discloses a laminated glass structure comprising a transparent electrode layer is coated on a glass sheet, wherein the stack also comprises a silicon film and a metal layer in this order.

Some conventional transparent oxide films such as indium tin oxide (indium tin oxide, ITO) films can further block electronic radiation, ultraviolet rays and far infrared rays harmful to human body due to their good characteristics of transparency and conductivity. Therefore, these transparent oxide films are usually sprayed on glass, plastic and an electronic display to be used as transparent conductive films and to reduce radiation harmful to human body as well as damage from ultraviolet and infrared lamps. When these transparent oxide films are applied to various electronic components such as electronic displays and projectors as transparent conductive layers by using conductive properties of these transparent oxide films, it is necessary to electrically connect the transparent oxide films to external circuits through an effective and reliable electrode connection. However, conventional electrical connection solutions cannot meet the requirements due to a limitation to reliability or a size of an operation space.

Currently, the transparent conductive films are connected to external circuits mainly through crimping and bonding. For example, a transparent conductive film is electrically connected to a PCB pad by using an anisotropic conductive film (anisotropic conductive film, ACF). However, the ACF has poor environmental reliability, and is prone to delamination and interface cracking and other shortcomings under temperature cycling and high temperature and high humidity environments.

Therefore, it is necessary to develop a more reliable way of connecting a transparent conductive electrode to an external circuit to meet electrical connectivity as well as connection reliability. In view of the problems, this application is put forward.

### SUMMARY

An objective of this application is to provide an electronic device comprising a conductive electrode to improve connection strength between the transparent conductive electrode and an external circuit and meet requirements for electrical connectivity and connection reliability, so as to resolve the problems in the foregoing background art or at least partially resolve the foregoing technical problems.

A first aspect of this application provides an electronic device as defined in claim 1.

The adhesive intermediate layer and especially the metal layer mainly formed by the precious metal are disposed on the transparent conductive film, which can improve properties of the transparent conductive film without affecting a conductive performance of the transparent conductive film, enhance bonding strength between the conductive electrode and the external circuit, thereby meeting requirements for electrical connection and reliability.

In a possible implementation, the precious metal includes, but is not limited to, at least one of Au (gold), Ag (silver), Pd (palladium), Pt (platinum), Rh (rhodium), or Ru (ruthenium);
preferably, the precious metal includes at least one of Au, Pd, or Pt; and
more preferably, the precious metal is Au.

The foregoing precious metal features stable performance, strong oxidation resistance, non-susceptibility to oxidation, high surface cleanliness and the like, and has good conductivity and excellent performance, and the bonding strength between the conductive electrode and the external circuit can be remarkably improved through bonding between the metal layer and the external circuit. In actual application, it is preferable to use a common precious metal such as Au, Pd or Pt, which features wide sources, good application effects, strong adaptability, and the like.

In a possible implementation, the adhesive intermediate layer is mainly formed by at least one of Cr (chromium), Ti (titanium), or stainless steel; and
preferably, the adhesive intermediate layer is mainly formed by Cr or Ti.

The adhesive intermediate layer may also be referred to as an intermediate bonding layer, which can improve adhesion of the metal layer and improve connection strength. It is difficult to fix the metal layer directly on the surface of the transparent conductive film, and the intermediate layer can improve adhesion of the metal layer and make the metal layer not easy to fall off. This can not only enhance the bonding strength between the conductive electrode and the external circuit and meet requirements for electrical connection and reliability, but also make the structure stable, make the connection firm and reliable, and achieve a better application effect. In particular, choosing any one or more of Cr, Ti or stainless steel (SUS) to form the adhesive intermediate layer has better practical application effects and is easy to implement, and the chosen one or more materials have a strong bonding force with the transparent conductive film and the metal layer.

In a possible implementation, the adhesive intermediate layer includes at least a first adhesive intermediate layer and a second adhesive intermediate layer; and
preferably, the first adhesive intermediate layer and the second adhesive intermediate layer are made of the same material.

It should be understood that there may be one, two or more adhesive intermediate layers. Preferably, two adhesive intermediate layers are provided. For example, the first layer is provided as the first adhesive intermediate layer, and the second layer is provided as the second adhesive intermediate layer. The first adhesive intermediate layer and the second adhesive intermediate layer may be made of the same material or different materials. Preferably, the first adhesive intermediate layer and the second adhesive intermediate layer are made of the same material, for example, are both Cr layers or Ti layers. The first adhesive intermediate layer is in direct contact with the surface of the transparent conductive film.

The two adhesive intermediate layers are mainly used to use the protective layer to protect the first adhesive intermediate layer, thereby increasing a bonding force between the first adhesive intermediate layer and the transparent conductive film, and improving firmness and reliability of the structure.

The conductive electrode further includes a protective layer, and the protective layer is disposed on an edge of the adhesive intermediate layer, or the protective layer is disposed on edges of both the adhesive intermediate layer and the metal layer.

In a possible implementation, an edge of the first adhesive intermediate layer is provided with a protective layer.

It may be understood that the conductive electrode includes a transparent conductive film, and an adhesive intermediate layer, a protective layer and a metal layer that are disposed on the transparent conductive film. The protective layer may be disposed on an edge of the adhesive intermediate layer, or disposed on edges of both the adhesive intermediate layer and the metal layer, to enhance the bonding force between the adhesive intermediate layer and the transparent conductive film and improve firmness and reliability of the structure. Preferably, the adhesive intermediate layer includes a first adhesive intermediate layer and a second adhesive intermediate layer; and an edge of the first adhesive intermediate layer is provided with a protective layer. The protective layer is used to protect the first adhesive intermediate layer, thereby increasing the bonding force between the first adhesive intermediate layer and the transparent conductive film.

In a possible implementation, the protective layer is mainly formed by at least one of a silicon-containing compound, an aluminum-containing compound, or a magnesium-containing compound;
preferably, the protective layer is mainly formed by SiO₂ (silicon dioxide), SiN (silicon nitride), or Al₂O₃ (aluminum oxide); and
preferably, the protective layer is mainly formed by SiO₂.

It may be understood that the protective layer may be formed by any one or more of various silicon-containing compounds, aluminum-containing compounds or magnesium-containing compounds, and can enhance the bonding force between the film and the adhesive intermediate layer and improve the structural connection or bonding performance. Preferably, because SiO₂ raw material may be used in the process of preparing the conductive electrode, SiO₂ is used to form the protective layer, which is characterized by better facilitating material taking, being economical and practical, and having good application effects.

In a possible implementation, a thickness of the protective layer is greater than that of the adhesive intermediate layer;
preferably, the thickness of the protective layer is greater than the sum of the thickness of the adhesive intermediate layer and a thickness of the metal layer, and
preferably, the thickness of the protective layer is greater than or equal to 1.0 µm, preferably greater than or equal to 1.5 µm, and more preferably about 2 µm. A protective layer with a larger thickness better protects the adhesive intermediate layer and improves the bonding force between the transparent conductive film and the adhesive intermediate layer.

In a possible implementation, the thickness of the adhesive intermediate layer is 50-100 nm. Preferably, the adhesive intermediate layer includes a first adhesive intermediate layer and a second adhesive intermediate layer, and the first adhesive intermediate layer and the second adhesive intermediate layer are each independently 50-100 nm.

In a possible implementation, the thickness of the metal layer is 75-300 nm.

The adhesive intermediate layer and the metal layer in the foregoing thickness range have better overall performance and better practical application effects.

In a possible implementation, a method for forming the adhesive intermediate layer includes deposition;
and/or, a method for forming the metal layer includes deposition;
preferably, the deposition includes physical vapor deposition (PVD) or chemical vapor deposition (CVD); and
preferably, the physical vapor deposition includes a magnetron sputtering method.

It should be understood that there are many methods of forming the foregoing adhesive intermediate layer or metal layer. For example, the deposition method may be used to form the adhesive intermediate layer on the surface of the transparent conductive film, and the deposition method may be used to form the metal layer on the surface of the adhesive intermediate layer. There may be various deposition methods. For example, various PVD methods or various CVD methods may be used. Preferably, the adhesive intermediate layer and the metal layer are prepared by using the magnetron sputtering method, which features good coating uniformity, ease of control over the film thickness, high productivity, high production efficiency, and the like.

In a possible implementation, the transparent conductive film includes, but is not limited to, at least one of an indium tin oxide (indium tin oxide, ITO) film, an indium zinc oxide (indium zinc oxide, IZO) film, an indium zinc tin oxide (ndium zinc tin oxide, IZTO) film, an indium aluminum zinc oxide (indium aluminum zinc oxide, IAZO) film, an indium gallium zinc oxide (indium gallium zinc oxide, IGZO) film, or an indium gallium tin oxide (indium gallium tin oxide, IGTO) film; and
preferably, the transparent conductive film is an ITO film.

In a possible implementation, the substrate includes glass; and the glass may be transparent glass, for example, ITO glass.

In a possible implementation, the external circuit has an external electrode, and the conductive electrode is bonded to the external electrode by using a conductive adhesive.

Preferably, the conductive adhesive includes a conductive silver adhesive.

It should be understood that this application mainly aims to alleviate the problems that in a technical solution of bonding a conventional transparent conductive electrode to an external electrode by using a conductive adhesive, bonding strength is low and delamination easily occurs to a bonding interface, and provides a novel conductive electrode, which increases the bonding force between the conductive electrode and a conductive adhesive, improves bonding reliability, and makes the connection firmer and more reliable.

The conductive adhesive may be various common conductive adhesives, such as a conductive silver adhesive, and more generally, the conductive adhesive may alternatively be any other adhesive that can be applied in the field.

In a possible implementation, the conductive electrode is bonded to a side face of the external electrode by using a conductive adhesive.

In a possible implementation, the conductive electrode is bonded to a lower surface of the external electrode by using a conductive adhesive.

In a possible implementation, the conductive electrode is bonded to the external electrode by using a conductive adhesive and a wire.

In scenarios in which a conductive adhesive is used to implement interconnection between a conductive adhesive and an external electrode, application characteristics may mainly fall into three types: the first type is that a side face of the external electrode is bonded for interconnection, that is, the conductive adhesive is used to bond the conductive adhesive to the side face of the external electrode for interconnection; the second type is that the external electrode is vertically bonded for interconnection, that is, the conductive adhesive is used to bond the conductive adhesive to a lower surface of the external electrode for interconnection; and the third type is that the external electrode is bonded by a wire for interconnection, that is, the conductive adhesive and the wire are used to implement interconnection between the conductive adhesive and the external electrode.

The conductive electrode according to this application can increase the bonding strength of the conductive adhesive on the conductive electrode, and compared with that of the prior art, the bonding strength of the conductive adhesive on the conductive electrode can be increased by about 1.5 times.

According to a second aspect of this application, a method for preparing a conductive electrode is further provided, including the following steps:
forming a transparent conductive film on a surface of a substrate;
forming an adhesive intermediate layer on a surface of the transparent conductive film; and
forming a metal layer on a surface of the adhesive intermediate layer, where the metal layer is mainly formed by a precious metal and configured to be bonded to an external circuit.

The conductive electrode obtained by using the method can improve properties of the transparent conductive film without affecting a conductive performance of the transparent conductive film, enhance bonding strength between the conductive electrode and the external circuit, thereby meeting requirements for electrical connection and reliability.

It should be understood that the preparation method is the method for preparing a conductive electrode described above, that is, the first aspect of this application corresponds to the second aspect thereof. Due to the document length limitation, the repeated part is not described in detail.

In a possible implementation, a deposition method is used to deposit the adhesive intermediate layer on the surface of the transparent conductive film;
and/or a deposition method is used to deposit the metal layer on the surface of the adhesive intermediate layer;
preferably, the deposition includes physical vapor deposition or chemical vapor deposition;
preferably, the physical vapor deposition includes a magnetron sputtering method;
preferably, the thickness of the adhesive intermediate layer is 50-100 nm; and
preferably, the thickness of the metal layer is 75-300 nm.

In a possible implementation, a deposition method is used to first deposit a first adhesive intermediate layer on the surface of the transparent conductive film, and then deposit a second adhesive intermediate layer on a surface of the first adhesive intermediate layer; and
preferably, the first adhesive intermediate layer and the second adhesive intermediate layer are made of the same material.

In a possible implementation, a deposition method is used to first deposit a first adhesive intermediate layer on the surface of the transparent conductive film, then coat an edge of the first adhesive intermediate layer with a protective layer, deposit a second adhesive intermediate layer on a surface of the first adhesive intermediate layer, and then deposit the metal layer on a surface of the second adhesive intermediate layer;
preferably, the protective layer is mainly formed by at least one of a silicon-containing compound, an aluminum-containing compound, or a magnesium-containing compound; preferably, the protective layer is mainly formed by at least one of SiO₂, SiN, or Al₂O₃; preferably, the protective layer is mainly formed by SiO₂; and
preferably, the thickness of the protective layer is greater than or equal to 1.0 µm.

In a possible implementation, the method includes the steps of coating with a photoresist, exposure, development and cleaning for many times.

It should be noted that in the foregoing operations, specific operations of coating with a photoresist, exposure, development and cleaning are not particularly limited in this application, and a person skilled in the art can learn by referring to the prior art that the operations can be performed in a manner well known in the art, and can be appropriately controlled by a person skilled in the art based on an actual situation.

In a possible implementation, a transparent conductive film is deposited on a surface of a substrate, and then cleaning, coating with a photoresist, exposure, development and patterned etching of a circuit are performed in sequence to obtain a basic conductive electrode; and
an adhesive intermediate layer and a metal layer are deposited on a surface of the basic conductive electrode in sequence to obtain a conductive electrode.

In a possible implementation, after a basic conductive electrode is obtained, cleaning, coating with a photoresist, exposure and development are performed on a transparent conductive film first, and an adhesive middle layer is deposited on a surface of the basic conductive electrode;
then cleaning, coating with a photoresist, exposure and development are performed again, and a metal layer is deposited on a surface of the adhesive middle layer;
preferably, after a basic conductive electrode is obtained, cleaning, coating with a photoresist, exposure and development are performed on a transparent conductive film first, and a first adhesive middle layer is deposited on a surface of the basic conductive electrode;
then cleaning, coating with a photoresist, exposure and development are performed again, and an edge surface of the first adhesive middle layer is coated with a protective layer; and
then cleaning, coating with a photoresist, exposure and development are performed again, a second adhesive middle layer is deposited on a surface of the first adhesive middle layer, and a metal layer is deposited on a surface of the second adhesive middle layer.

In a possible implementation, detection is performed after each cleaning. After each cleaning process, it is necessary to strictly inspect whether the electrode is cleaned to ensure that there is no photoresist residue. For example, a 100X optical microscope may be used to fully inspect each electrode.

Preferably, cleaning is performed for about 7 h every time; and in this way, the electrode can be cleaned.

In a possible implementation, the precious metal includes at least one of Au, Ag, Pd, Pt, Rh, or Ru; preferably, the precious metal includes at least one of Au, Pd, or Pt; and preferably, the precious metal is Au.

In a possible implementation, the adhesive intermediate layer is mainly formed by at least one of Cr, Ti, or stainless steel; and preferably, the adhesive intermediate layer is mainly formed by Cr or Ti.

In a possible implementation, the transparent conductive film includes at least one of an indium tin oxide film, an indium zinc oxide film, a zinc indium tin oxide film, an indium zinc aluminum oxide film, a zinc indium gallium oxide film, or a gallium indium tin oxide film; preferably, the transparent conductive film is an indium tin oxide film; and
preferably, the substrate includes glass.

In a possible implementation, the prepared conductive electrode is bonded to a side face of the external electrode by using a conductive adhesive;
or, the prepared conductive electrode is bonded to a lower surface of the external electrode by using a conductive adhesive;
or, the prepared conductive electrode is bonded to the external electrode by using a conductive adhesive and a wire.

An electronic device is provided, including an external circuit (an external electrode), and further including the conductive electrode described above or the conductive electrode obtained by using the foregoing method. The metal layer is connected to the external circuit through bonding.

In a possible implementation, the electronic device includes a projector, the projector includes an external circuit, and the metal layer in the conductive electrode is connected to the external circuit through bonding.

In a possible implementation, the electronic device includes a camera shooting apparatus, the camera shooting apparatus includes an external circuit, and the metal layer in the conductive electrode is connected to the external circuit through bonding.

The foregoing conductive electrode may be applied in various electronic displays, projectors and other electronic components as a transparent conductive layer. The conductive electrode may be included in an electronic device. The electronic device may include a camera shooting apparatus. The camera shooting apparatus may include a projector. The projector includes the foregoing transparent conductive electrode and an external electrode. A conductive adhesive is used to implement effective and reliable electrical interconnection between the foregoing transparent conductive electrode and the external electrode.

The technical solution according to this application can achieve the following beneficial effects:
In the conductive electrode and the preparation method thereof, the adhesive intermediate layer and especially the metal layer mainly formed by the precious metal are disposed on the transparent conductive film, which can improve properties of the transparent conductive film without affecting a conductive performance of the transparent conductive film, enhance bonding strength between the conductive electrode and the external circuit, thereby meeting requirements for electrical connection and reliability, and implementing effective and reliable electrical interconnection between the conductive electrode and the external circuit. Moreover, the adhesive intermediate layer can improve adhesion of the metal layer and enhance stability and reliability of the entire structure.

The electronic device according to this application includes the foregoing conductive electrode, and therefore has at least the same advantages as the foregoing conductive electrode. Details are not described herein again.

It should be understood that the foregoing general description and the following detailed description are only exemplary and cannot limit this application.

### BRIEF DESCRIPTION OF DRAWINGS

To describe the technical solutions of embodiments of this application more clearly, the following briefly describes accompanying drawings required in the embodiments of this application. A person of ordinary skill in the art may still derive other accompanying drawings from these accompanying drawings without creative efforts.
FIG. 1 is a schematic diagram of bonding between a conductive electrode and an external electrode in the prior art;
FIG. 2 is a schematic structural diagram of a conductive electrode according to an example implementation of this application;
FIG. 3 is a schematic structural diagram of a conductive electrode according to another example implementation of this application;
FIG. 4 is a schematic structural diagram of a conductive electrode according to still another example implementation of this application;
FIG. 5 is a schematic structural diagram of a conductive electrode according to yet another example implementation of this application;
FIG. 6 is a schematic diagram of a method of connecting a conductive electrode to an external electrode according to an example implementation of this application;
FIG. 7 is a schematic diagram of a method of connecting a conductive electrode to an external electrode according to another example implementation of this application;
FIG. 8 is a schematic diagram of a method of connecting a conductive electrode to an external electrode according to still another example implementation of this application;
FIG. 9 is a schematic flowchart of a method for preparing a conductive electrode according to an example implementation of this application; and
FIG. 10 is a schematic diagram of bonding strength of a conductive electrode according to an example implementation of this application.

The description of reference numerals is as follows:
1: conductive electrode;
100: glass substrate; 101: ITO film; 102: adhesive intermediate layer; 1021: first adhesive intermediate layer; 1022: second adhesive intermediate layer; 103: protective layer; 104: metal layer; 110: ITO line;
2: external electrode;
3: conductive adhesive;
4: wire.

The accompanying drawings herein are incorporated into the specification and constitute a part of the specification, show embodiments that conform to this application, and are used together with the specification to explain the principle of this application.

### DESCRIPTION OF EMBODIMENTS

To better understand the technical solutions of this application, embodiments of this application are described in detail below with reference to the accompanying drawings.

It should be noted that the term "and/or" used herein is only used to describe an association relationship between associated objects, and indicates that three relationships may exist. For example, A and/or B may indicate the following: Only A exists, both A and B exist, and only B exists.

Unless otherwise defined or illustrated, the professional and scientific terms used herein have the same meaning as those familiar to a person skilled in the art.

A person skilled in the art shall understand that, as described in the background art, conventional electrical connection solutions of a transparent conductive electrode cannot meet the requirements due to a limitation to reliability or a size of an operation space. Taking an ITO electrode as an example, a method of connecting a conventional transparent conductive electrode to an external circuit is described in detail. It should be understood that other related transparent conductive electrodes also have the same or similar problems.

First, a conventional technology of using an ACF to implement interconnection between the ITO electrode and an external electrode through crimping is applied to a solution of a liquid crystal display. The ACF is prefabricated between the ITO electrode and the external electrode, and a certain pressure is applied to the ACF to make conductive ions in the ACF be in contact with upper and lower electrodes, thereby implementing interconnection between the ITO electrode and the external circuit. However, in this solution: (1) A certain pressure needs to be applied during use of the ACF to ensure that conductive particles in the ACF are in contact with the ITO electrode and the external electrode. The existence of pressure causes substrate warpage (> 50 µm), which affects assembly accuracy; applied pressure must be uniform, so that a certain process difficulty exists in assembly of large-size devices. (2) The existence of resin in the ACF leads to a large contact resistance at a connection point, which cannot withstand high voltage and large current. When a distance is relatively small and high voltage is applied, ACF breakdown occurs easily. (3) The ACF is prone to delamination, cracking and other failures in environmental reliability tests such as in high temperature and high humidity and temperature cycling environments, causing electrical connection failure.

Second, a conventional technical solution of welding a conductive outer wire for interconnection is provided. In this technology, a screen printing method is used to print silver paste on an ITO electrode, then a test piece is placed in a muffle furnace and kept at 360°C-400°C for 5-10 minutes to achieve metallization on the ITO electrode, and an electric soldering iron and a solder wire are used to solder a wire on the sintered silver layer, so as to realize the interconnection between the ITO electrode and the external circuit. In this solution, a solder joint is in ohmic contact, and the contact resistance is small; and because the wire is used for connection, the connection reliability is good. However, in this solution: (1) Raw materials required for the preparation of glass powder and silver paste contain lead oxide, lead borate and other lead-containing inorganic substances, which do not meet environmental protection requirements on consumer electronics. (2) Sintering of the silver paste needs to be performed at a high temperature of 360°C-400°C, and high-temperature baking causes further oxidation of the ITO film, thereby affecting electrical properties of the ITO film. (3) Manual welding of an outer wire does not facilitate operations and occupies a relatively large space structure, which does not facilitate device miniaturization.

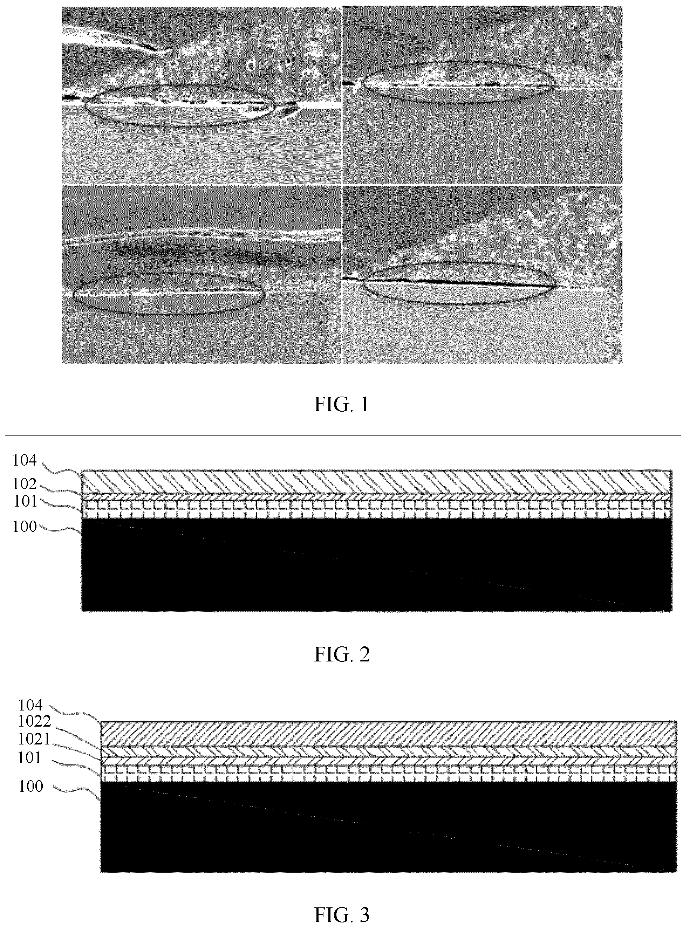

Third, a conventional technical solution of bonding by using a conductive adhesive (such as a conductive silver adhesive) is provided. A conductive adhesive is used for direct bonding. First a tool or a structural part is used to fix and align the ITO electrode with the external electrode, and then a dispenser is used to directly dispense the conductive silver adhesive in a gap between the ITO electrode and the external electrode, and the conductive silver adhesive is heated for curing. Silver particles in the conductive silver adhesive form a mesh network in the silver adhesive, so as to realize electrical interconnection between the ITO electrode and the external electrode. However, in this solution, as shown in FIG. 1, if the conductive silver adhesive is directly used on the ITO electrode for interconnection, a reliability test shows that delamination and cracking and other shortcomings occur due to insufficient bonding strength. If silver paste is sintered on the ITO electrode first to form bumps and then a wire is soldered for interconnection, it is difficult to perform such operations because the ITO electrode has a smaller area. The wire soldering also occupies more assembly space. In addition, the ITO is further oxidized during sintering to change the structure, which affects electrical properties of an ITO trace.

A person skilled in the art understands that if the conductive silver adhesive is used to directly bond the ITO film to an external conductor electrode, due to the special surface of the ITO film material, the surface is smooth and specific surface energy is higher (a contact angle between the ITO film and the a water drop is greater than 35°), and the bonding strength with the silver adhesive is lower (about 8-12 MPa). After thermal fatigue and mechanical reliability tests, the bonding interface is prone to delamination (refer to FIG. 1). In addition, because a thermal expansion coefficient of the conductive silver adhesive (50-70 ppm) is quite different from that of glass (3-7 ppm), delamination and cracking easily occur to a bonding interface under the action of thermal shock or alternating temperature, thereby leading to electrical connection failure. In addition, due to the higher specific surface energy of the ITO surface, the surface easily adsorbs dust particles, which leads to dust pollution on the ITO surface.

Therefore, to overcome the shortcomings of the prior art, technical solutions of embodiments of this application provide a conductive electrode, a preparation method thereof, and an electronic device. An adhesive intermediate layer and a metal mainly formed by a precious metal are prepared on a transparent conductive film, which changes surface properties of a transparent conductive film, prevents delamination occurring to a bonding interface, enhances a bonding force between the conductive electrode and a conductive adhesive, improve bonding reliability, and can further reduce or prevent surface dust pollution.

In a specific implementation, this application is further described in detail below based on specific embodiments with reference to the accompanying drawings.

Referring to FIG. 2 to FIG. 10, an embodiment of this application provides an electronic device. The electronic device according to the embodiment of this application may be an electronic device with an imaging function, and for example, may be a mobile phone, a tablet computer, a notebook computer, a display device, a recorder or an information display device.

In some implementations, the electronic device includes a camera, the camera includes an external electrode 2 and a conductive electrode 1, and the conductive electrode 1 is bonded to the external electrode 2 by using a conductive adhesive 3.

In some implementations, the electronic device includes a projector, the projector includes an external electrode 2 and a conductive electrode 1, and the conductive electrode 1 is bonded to the external electrode 2 by using a conductive adhesive 3.

Specifically, the projector includes a frame, the frame is provided with an external electrode 2, and the conductive electrode 1 is bonded to the frame.

A basic technology of interconnection between a transparent conductive electrode and an external electrode by using a conductive silver adhesive according to the technical solution of the present embodiment can be used for assembly of electronic components such as an electronic display (such as a liquid crystal display or an electroluminescent display), a projector module, a microwave shield and safety goggles.

As shown in FIG. 2 to FIG. 10, an embodiment of this application provides a conductive electrode. The conductive electrode 1 may include a glass substrate 100, a transparent conductive film disposed on a surface of the glass substrate 100, an adhesive intermediate layer 102 disposed on a surface of the transparent conductive film and a metal layer 104 disposed on a surface of the adhesive intermediate layer 102. The metal layer 104 is mainly formed by a precious metal and configured to be bonded to an external circuit.

The glass substrate 100 may be transparent glass. Specifically, the glass substrate 100 may be ITO glass. More generally, the glass substrate 100 may alternatively be any other transparent glass. The embodiment of this application mainly takes the ITO glass as a substrate as an example to further describe the conductive electrode in detail.

The transparent conductive film may be an indium tin oxide film (ITO film), an indium zinc oxide film (IZO film), a zinc indium tin oxide film (IZTO film), an indium zinc aluminum oxide film (IAZO film). ), a zinc indium gallium oxide film (IGZO film), or a gallium indium tin oxide film (IGTO film). More generally, the transparent conductive film may alternatively another similar oxide film. The ITO film has good transparency and conductivity, can block electronic radiation, ultraviolet rays and far infrared rays harmful to the human body, has excellent photoelectric properties and electrode processing properties, and has better practical application effects.

For simplicity, the embodiment of this application mainly uses the ITO film 101 as a transparent conductive film as an example to describe the conductive electrode and the preparation method thereof in detail. Therefore, the conductive electrode 1 may also be referred to as an ITO electrode.

In some specific implementations, the external circuit has an external electrode 2, and the conductive electrode 1 is bonded to the external electrode 2 by using a conductive adhesive 3. The conductive adhesive 3 may be various common conductive adhesives, such as a conductive silver adhesive, and more generally, the conductive adhesive may alternatively be any other adhesive that can be applied in the field.

In some implementations, the conductive adhesive 3 is a conductive silver adhesive.

A person skilled in the art shall understand that, to alleviate the problems that in a technical solution of bonding a conventional transparent conductive electrode to an external electrode by using a conductive adhesive, bonding strength is low and delamination easily occurs to a bonding interface, a conductive electrode according to this application is provided, which can increase the bonding force between the conductive electrode and a conductive adhesive, improve bonding reliability, and makes the connection between the conductive electrode and the external electrode firmer and more reliable.

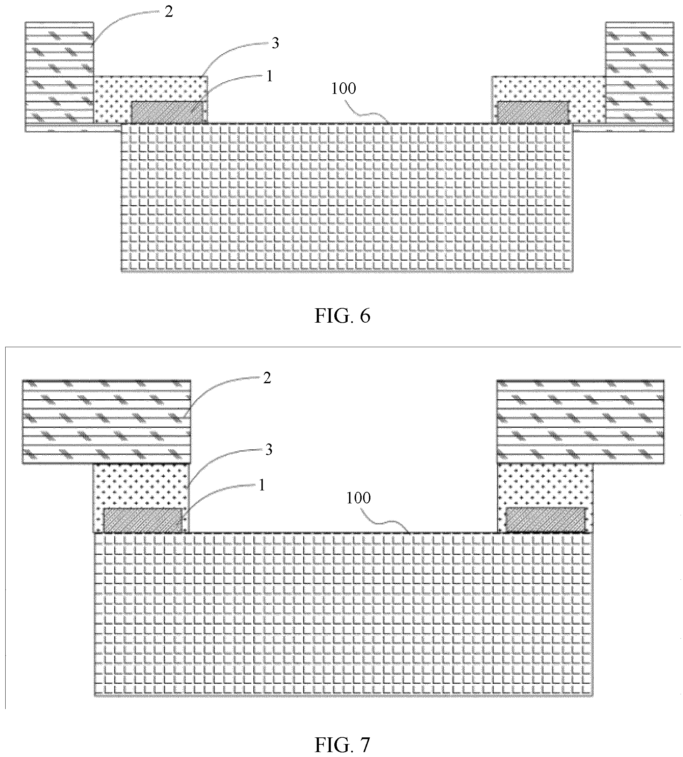

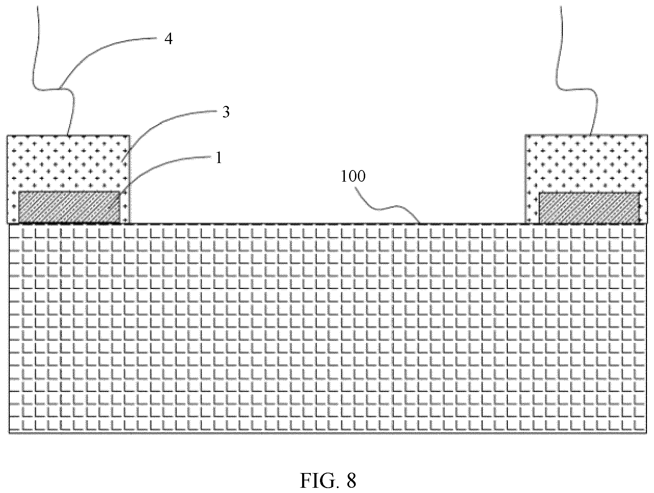

Specifically, as shown in FIG. 6 to FIG. 8, in scenarios in which a conductive adhesive 3 is used to implement interconnection between the foregoing conductive adhesive 1 and an external electrode 2, application characteristics may mainly fall into three types:
the first type is that, as shown in FIG. 6, a side face of the external electrode 2 is bonded for interconnection, that is, the conductive adhesive 3 is used to bond the conductive adhesive 1 to the side face of the external electrode 2 for interconnection;
the second type is that, as shown in FIG. 7, the external electrode 2 is vertically bonded for interconnection, that is, the conductive adhesive 3 is used to bond the conductive adhesive 1 to a lower surface of the external electrode 2 for interconnection; and
the third type is that, as shown in FIG. 8, the external electrode 2 is bonded by a wire for interconnection, that is, the conductive adhesive 3 and the wire 4 are used to implement interconnection between the conductive adhesive 1 and the external electrode 2.

In actual application, any one or several of the foregoing connection methods may be selected based on the architecture of a specific electronic device product.

In some specific embodiments, the precious metal includes, but is not limited to, at least one of Au, Ag, Pd, Pt, Rh, or Ru. For example, the precious metal may be Au, Ag, Pd, Pt, Rh, Ru, or the like. In some embodiments, the precious metal may be Au, or Pd, or Pt. The metal layer formed by these precious metals not only has good electrical conductivity, but also has stable chemical properties and strong oxidation resistance, is not prone to oxidization, has high surface cleanliness, can prevent dust pollution, and can greatly improve bonding strength with the conductive silver adhesive and improve bonding reliability.

For example, in some implementations, the metal layer 104 is an Au layer, and can have the conductive effect and adhesive property of the Au material. It may be understood that the metal layer according to the embodiment of this application may be an Au layer, which features wide sources, ease of obtaining, excellent oxidation resistance, good conductivity, ease of surface bonding, better practical application effects, strong adaptability, and the like.

For another example, in an embodiment, the metal layer 104 is a Pt layer, and can have the conductive effect and adhesive property of the Pt material. It may be understood that the metal layer according to the embodiment of this application may be a Pt layer, and features stable performance, strong oxidation resistance, high surface cleanliness, good conductivity, ease of surface bonding, and the like.

For example, in some implementations, the metal layer 104 is an Au layer, and can have the conductive effect and adhesion property of the Pd material. It may be understood that the metal layer according to the embodiment of this application may be a Pd layer, and features stable performance, strong oxidation resistance, high surface cleanliness, good conductivity, ease of surface bonding, and the like.

In some cases, it is difficult to fix the metal layer 104 directly on the surface of the ITO film 101, the intermediate layer can improve adhesion of the metal layer and make the metal layer not easy to fall off. This not only can enhance the bonding strength between the conductive electrode and the external circuit and meet requirements for electrical connection and reliability, but also makes the structure stable and reliable and improves reliability of the conductive electrode.

In some specific implementations, the adhesive intermediate layer 102 is mainly formed by at least one of Cr, Ti, or stainless steel (SUS). For example, the adhesive intermediate layer 102 may be a Cr layer, or a Ti layer, or a stainless steel (SUS) layer, or the like. The adhesive intermediate layer 102 disposed between the ITO film 101 and the metal layer 104 can improve adhesion between the ITO film 101 and the metal layer 104.

For example, in some implementations, the adhesive intermediate layer 102 is a Cr layer, and can have the connection effect or adhesion performance of the Cr material.

For example, in an implementation, the adhesive intermediate layer 102 is a Ti layer, and can have the connection effect or adhesion performance of the Ti material.

A person skilled in the art shall understand that both Cr and Ti are commonly used bonding layer metals in a semiconductor technology, the resources are easy to obtain, and the metals have excellent bonding performance with Si or a ceramic material.

In some specific implementations, the adhesive intermediate layer 102 includes a first adhesive intermediate layer 1021 and a second adhesive intermediate layer 1022, that is, two adhesive intermediate layers may be provided. The first adhesive intermediate layer 1021 is deposited on a surface of the ITO film 101, and the second adhesive intermediate layer 1022 is deposited on a surface of the first adhesive intermediate layer 1021.

The two adhesive intermediate layers are mainly used to use the protective layer to protect the first adhesive intermediate layer, thereby increasing a bonding force between the first adhesive intermediate layer and the transparent conductive film, and improving firmness and reliability of the structure.

Specifically, the first adhesive intermediate layer 1021 and the second adhesive intermediate layer 1022 may be made of the same metal material, or different metal materials. In some implementations, the first adhesive intermediate layer 1021 and the second adhesive intermediate layer 1022 may be made of the same material. For example, the first adhesive intermediate layer 1021 may be a Cr1 layer, the second adhesive intermediate layer 1022 may be a Cr2 layer, or the first adhesive intermediate layer 1021 may be a Ti1 layer, and the second adhesive intermediate layer 1022 may be a Ti2 layer.

In some specific implementations, the conductive electrode 1 further includes a protective layer 103, and the protective layer 103 is disposed on an edge of the adhesive intermediate layer 102, or the protective layer 103 is disposed on edges of both the adhesive intermediate layer 102 and the metal layer 104.

The conductive electrode 1 includes an ITO film 101, and an adhesive intermediate layer 102, a protective layer 103 and a metal layer 104 that are disposed on the ITO film 101. The protective layer 103 may be disposed on an edge of the adhesive intermediate layer 102, or disposed on edges of both the adhesive intermediate layer 102 and the metal layer 104, to enhance the bonding force between the adhesive intermediate layer and the transparent conductive film and improve firmness and reliability of the structure.

It should be understood that the surface of the first adhesive intermediate layer 1021 is coated with the protective layer 103, especially a peripheral edge (peripheral part) of the first adhesive intermediate layer 1021 is coated with the protective layer 103, and the thickness of the protective layer 103 may be higher. In this way, the bonding force between the first adhesive intermediate layer 1021 and the ITO film 101 can be enhanced, and the structure is more stable and reliable. The specific width or length of the protective layer is not specifically limited and can be adjusted by a person skilled in the art based on an actual situation.

In some specific implementations, the adhesive intermediate layer 102 includes a first adhesive intermediate layer 1021 and a second adhesive intermediate layer 1022, and an edge of the first adhesive intermediate layer 1021 is provided with a protective layer 103. The protective layer 103 is used to protect the first adhesive intermediate layer 1021, thereby increasing the bonding force between the first adhesive intermediate layer 1021 and the ITO film 101, and ensuring that no delamination occurs between the first adhesive intermediate layer 1021 and the ITO film 101, especially in an edge region.

In some specific implementations, the protective layer 103 is mainly formed by at least one of a silicon-containing compound, an aluminum-containing compound, or a magnesium-containing compound. For example, the protective layer 103 may be formed by a silicon-containing compound, or an aluminum-containing compound, or a magnesium-containing compound. Preferably, the protective layer 103 is formed by a silicon-containing compound or an aluminum-containing compound. The silicon-containing compound may be, for example, SiO₂, or SiN. The magnesium-containing compound may be Al₂O₃, or the like. The use of the foregoing compound as a protective layer can effectively protect the first adhesive intermediate layer and increase the bonding force between the first adhesive intermediate layer and the ITO film.

In some implementations, the protective layer 103 is mainly formed by SiO₂. Because SiO₂ raw material may be used in the process of preparing the conductive electrode (glass substrate), SiO₂ is used to form the protective layer, which is characterized by better facilitating material taking, being economical and practical, and having good application effects.

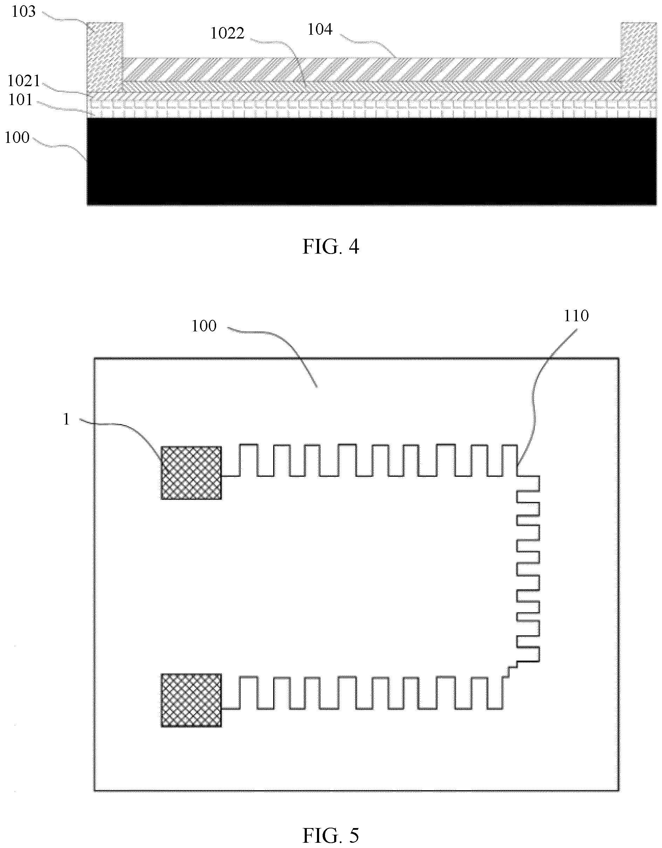

Specifically, as shown in FIG. 4, in an implementation, the conductive electrode 1 includes a glass substrate 100, an ITO film 101 disposed on a surface of the glass substrate 100, a Cr1 layer (first adhesive intermediate layer 1021) disposed on a surface of the ITO film 101, a SiO₂ protective layer 103 disposed on an edge of the Cr1 layer, a Cr2 layer (second adhesive intermediate layer 1022) disposed on a surface of the Cr1 layer and an Au layer (metal layer 104) disposed on a surface of the Cr2 layer.

Specifically, referring to FIG. 4, in an implementation, the conductive electrode 1 includes a glass substrate 100, an ITO film 101 disposed on a surface of the glass substrate 100, a Ti1 layer disposed on a surface of the ITO film 101, a SiO₂protective layer 103 disposed on an edge of the Ti1 layer, a Ti2 layer disposed on a surface of the Ti1 layer and an Au layer disposed on a surface of the Ti2 layer.

Specifically, as shown in FIG. 4, in an implementation, the conductive electrode 1 includes a glass substrate 100, an ITO film 101 disposed on a surface of the glass substrate 100, a Cr1 layer disposed on a surface of the ITO film 101, a SiO₂ protective layer disposed on an edge of the Cr1 layer, a Cr2 layer disposed on a surface of the Cr1 layer and a Pt layer disposed on a surface of the Cr2 layer.

A person skilled in the art shall understand that the SiO₂ protective layer 103 may be disposed on an edge surface of the Cr1 layer, and the Cr2 layer may be disposed on the surface of the Cr1 layer other than the edge surface of the Cr1 layer.

In some specific implementations, the thickness of the protective layer 103 is greater than that of the adhesive intermediate layer 102. In some implementations, the thickness of the protective layer 103 is greater than the total of the thickness of the adhesive intermediate layer 102 and the thickness of the metal layer 104.

The thickness of the protective layer 103 may be, for example, greater than or equal to 1.0 µm, preferably greater than or equal to 1.5 µm, more preferably about 2 µm, and typically but non-restrictively, for example, 1.5 µm, 1.8 µm, 2.0 µm, 2.2 µm or 2.5 µm.

In some specific implementations, the thickness of the adhesive intermediate layer 102 is 50-100 nm. Further, the adhesive intermediate layer 102 includes a first adhesive intermediate layer 1021 and a second adhesive intermediate layer 1022, and the first adhesive intermediate layer 1021 and the second adhesive intermediate layer 1022 are each independently 50-100 nm, that is, the thicknesses of the first adhesive intermediate layer 1021 and the second adhesive intermediate layer 1022 are controlled to be 50-100 nm.

In some specific implementations, the thickness of the metal layer 104 is 75-300 nm.

Based on comprehensive consideration of application reliability and processing costs, the protective layer, the metal layer or the adhesive intermediate layer within the foregoing thickness range is selected. For example, when the thickness of the adhesive intermediate layer 102 is less than 50 nm, its compactness is insufficient, which affects adhesion of a coating, thereby affecting reliability; when the thickness is excessively large, coating efficiency is affected and is excessively low, and a manufacturing cost is increased. The adhesive intermediate layer and the metal layer in the foregoing thickness range may have better overall performance and better practical application effects.

In some specific implementations, a method for forming the adhesive intermediate layer 102 includes deposition;
and/or, a method for forming the metal layer 104 includes deposition;
in some implementations, the deposition includes physical vapor deposition (PVD) or chemical vapor deposition (CVD); and
in some implementations, the physical vapor deposition includes a magnetron sputtering method.

It should be understood that there are many methods of forming the foregoing adhesive intermediate layer or metal layer. For example, the deposition method may be used to form the adhesive intermediate layer on the surface of the transparent conductive film, and the deposition method may be used to form the metal layer on the surface of the adhesive intermediate layer. There may be various deposition methods. For example, various PVD methods or various CVD methods may be used. In some implementations, the adhesive intermediate layer and the metal layer are prepared by using the magnetron sputtering method, which features good coating uniformity, ease of control over the film thickness, high productivity, high production efficiency, and the like.

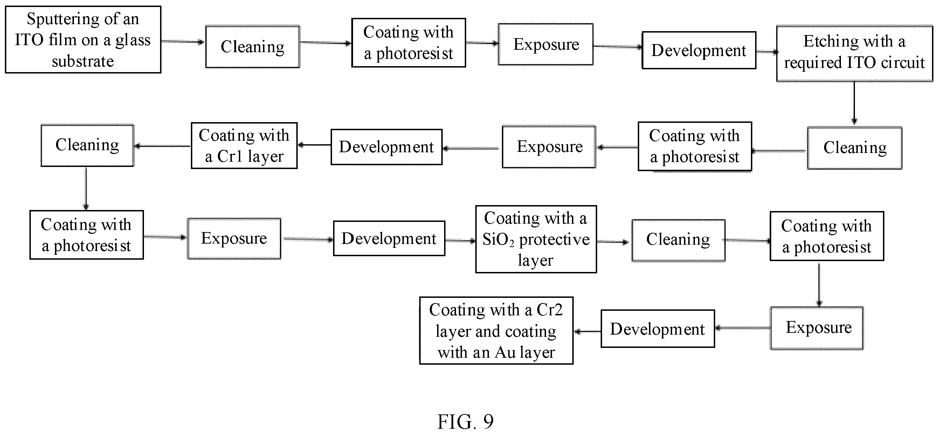

FIG. 9 is a schematic flowchart of a method for preparing a conductive electrode according to an example implementation of this application.

As shown in FIG. 9, a method for preparing a conductive electrode 1 may include:
preparing an ITO film 101 on a surface of a glass substrate 100;
preparing an adhesive intermediate layer 102 on a surface of the ITO film 101; and
preparing a metal layer 104 mainly formed by a precious metal on a surface of the adhesive intermediate layer 102.

The foregoing method for preparing the ITO film 101, the adhesive intermediate layer 102 and the metal layer 104 is preferably a magnetron sputtering method. The adhesive intermediate layer 102 and the metal layer 104 are prepared on the ITO film 101 by using the magnetron sputtering method, which improves surface properties of the ITO, increases a bonding force (bonding strength) between the ITO electrode and the conductive adhesive, and improves bonding reliability between the conductive electrode and the external electrode.

In some implementations, the magnetron sputtering method is used to first deposit a first adhesive intermediate layer 1021 on a surface of the ITO film 101, and then deposit a second adhesive intermediate layer 1022 on a surface of the first adhesive intermediate layer 1021. In some implementations, the first adhesive intermediate layer 1021 and the second adhesive intermediate layer 1022 are made of the same material.

In some implementations, the magnetron sputtering method is used to first deposit a first adhesive intermediate layer 1021 on the surface of the ITO film 101, then coat an edge of the first adhesive intermediate layer 1021 with a protective layer 103, deposit a second adhesive intermediate layer 1022 on a surface of the first adhesive intermediate layer 1021, and then deposit a metal layer 104 on a surface of the second adhesive intermediate layer 1022.

In some implementation, the method includes the steps of coating with a photoresist, exposure, development and cleaning for many times.

It should be noted that in the foregoing operations, specific operations of coating with a photoresist, exposure, development and cleaning are not particularly limited in this application, and a person skilled in the art can learn by referring to the prior art that the operations can be performed in a manner well known in the art, and can be appropriately controlled by a person skilled in the art based on an actual situation.

In some implementations, the method includes: depositing an ITO film 101 on a surface of a glass substrate 100, and then performing cleaning, coating with a photoresist, exposure, development and patterned etching of a circuit in sequence to obtain a basic conductive electrode; and
depositing an adhesive intermediate layer 102 and a metal layer 104 on a surface of the basic conductive electrode in sequence to obtain a conductive electrode 1.

In some implementations, after a basic conductive electrode is obtained, cleaning, coating with a photoresist, exposure and development are performed on an ITO film 101 first, and an adhesive middle layer 102 is deposited on a surface of the basic conductive electrode; and
then cleaning, coating with a photoresist, exposure and development are performed again, and a metal layer 104 is deposited on a surface of the adhesive middle layer 102.

In some implementations, after a basic conductive electrode is obtained, cleaning, coating with a photoresist, exposure and development are performed on an ITO film 101 first, and a first adhesive middle layer 1021 is deposited on a surface of the basic conductive electrode;
then cleaning, coating with a photoresist, exposure and development are performed again, and an edge surface of the first adhesive middle layer 1021 is coated with a protective layer 103; and
then cleaning, coating with a photoresist, exposure and development are performed again, a second adhesive middle layer 1022 is deposited on a surface of the first adhesive middle layer 1021, and a metal layer 104 is deposited on a surface of the second adhesive middle layer 1022.

In some implementations, detection is performed after each cleaning. After each cleaning process, it is necessary to strictly inspect whether the electrode is cleaned to ensure that there is no photoresist residue. For example, a 100X optical microscope may be used to fully inspect each electrode.

In some implementations, cleaning is performed for about 7 h every time; and in this way, the electrode can be cleaned.

Specifically, as shown in FIG. 4, FIG. 5 and FIG. 9, the conductive electrode 1 including a glass substrate 100, an ITO film 101 disposed on a surface of the glass substrate 100, a Cr1 layer disposed on a surface of the ITO film 101, a SiO₂ protective layer disposed on an edge of the Cr1 layer, a Cr2 layer disposed on a surface of the Cr1 layer and an Au layer disposed on a surface of the Cr2 layer is taken as an example to describe in detail a specific process of preparing a Cr/Au coating by using the magnetron sputtering method.

The method includes: sputtering an ITO film 101 on a surface of a glass substrate 100, and then performing cleaning, coating with a photoresist, exposure, development and etching with a required ITO circuit (patterned circuit etching with the required ITO line 110) to obtain a basic conductive electrode;
after the basic conductive electrode is obtained, performing cleaning, coating with a photoresist, exposure and development on an ITO film 101 first, and depositing a Cr1 layer on a surface of the basic conductive electrode;
then performing cleaning, coating with a photoresist, exposure and development again, and coating an edge surface of the Cr1 layer with a SiO₂ protective layer 103; and
then performing cleaning, coating with a photoresist, exposure and development again, depositing a Cr2 layer on a surface of the Cr1 layer, and depositing a metal layer 104 on a surface of the Cr2 layer.

The process of coating with a photoresist, exposure, development and cleaning is performed for many times during preparation of the Cr/Au layer, and detection is required after each cleaning. After each cleaning process, it is necessary to strictly inspect whether the electrode is cleaned to ensure that there is no photoresist residue. For example, a 100X optical microscope may be used to fully inspect each electrode.

A double-layer Cr coating process is adopted, and the edge of the first Cr1 layer is coated with the SiO₂ protective layer, which can ensure that no delamination occurs between the Cr1 layer and the ITO film, especially in an edge region.

A person skilled in the art shall understand that when the first adhesive intermediate layer 1021 and the second adhesive intermediate layer 1022 are a Ti1 layer and a Ti2 layer, respectively, or the metal layer 104 is a Pt layer or a Pd layer, or other adhesive intermediate layers or metal layers are adopted, they can all be prepared by using the process.

A process of coating with double adhesive intermediate layers is used. The edge of the first adhesive intermediate layer 1021 is coated with the protective layer 103, which can ensure that no delamination occurs between the first adhesive intermediate layer 1021 and the ITO film 101. The two adhesive intermediate layers are provided mainly to use the protective layer to protect the first adhesive intermediate layer, so as to increase a bonding force between the first adhesive intermediate layer and the ITO film, especially in an edge region.

The adhesive intermediate layer and the metal layer are prepared by using the magnetron sputtering method, which features good coating uniformity, ease of control over the film thickness, high productivity, and the like. Through magnetron sputtering of target source materials and program setting, a batch of materials can be coated with a Cr/Au layer in one time, further improving UPH.

After the coating is completed, due to a significant color difference between the Au surface and the Cr surface and other contaminated surfaces, automatic full inspection of a device CCD can be realized to fully ensure quality of Au-coated products.

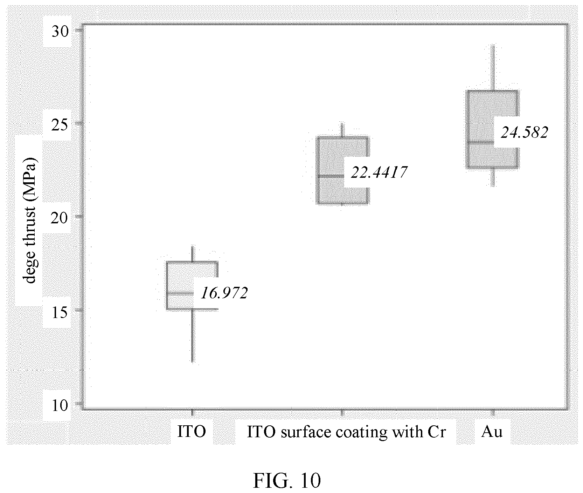

It can be learned from FIG. 10 that the conductive electrode according to this application can increase the bonding strength of the conductive adhesive on the conductive electrode, and compared with the prior art, the conductive electrode according to this application can increase bonding strength of the conductive adhesive on the conductive electrode by about 1.5 times.

It should be understood that the contents not described in detail in the description of an electronic device after the foregoing method for preparing a conductive electrode are common structures or operating parameters easily thought of by a person skilled in the art, such as specific operations of coating with a photoresist, exposure, development and the like, and can be adjusted with reference to the prior art or by a person skilled in the art based on an actual situation, so that detailed description thereof may be omitted.

## Claims

1. An electronic device, comprising an external circuit, wherein the electronic device comprises a conductive electrode, the conductive electrode comprising:
a transparent conductive film disposed on a substrate;
an adhesive intermediate layer disposed on the transparent conductive film; and
a metal layer disposed on the adhesive intermediate layer, where the metal layer is mainly formed by a precious metal and configured to be bonded to an external circuit;
wherein the conductive electrode further comprises a protective layer, and the protective layer is disposed on an edge of the adhesive intermediate layer, or the protective layer is disposed on edges of both the adhesive intermediate layer and the metal layer;
wherein the metal layer is connected to the external circuit through bonding.

2. The electronic device according to claim 1, wherein an edge of the first adhesive intermediate layer is provided with a protective layer.

3. The electronic device according to claim 1 or 2, wherein the protective layer is mainly formed by at least one of a silicon-containing compound, an aluminum-containing compound, or a magnesium-containing compound, and is preferably mainly formed by at least one of SiO₂, SiN, or Al₂O₃.

4. The electronic device according to claim 1 or 2, wherein a thickness of the protective layer is greater than that of the adhesive intermediate layer;
or, the thickness of the protective layer is greater than the sum of the thickness of the adhesive intermediate layer and a thickness of the metal layer.

5. The electronic device according to claim 1, wherein the thickness of the adhesive intermediate layer is 50-100 nm.

6. The electronic device according to claim 1, wherein the thickness of the metal layer is 75-300 nm.

7. The electronic device according to claim 1, wherein a method for forming the adhesive intermediate layer comprises deposition, and is preferably a magnetron sputtering method;
and/or, a method for forming the metal layer comprises deposition, and is preferably a magnetron sputtering method.

8. The electronic device according to claim 1, wherein the transparent conductive film comprises at least one of an indium tin oxide film, an indium zinc oxide film, an indium zinc tin oxide film, an indium aluminum zinc oxide film, an indium gallium zinc oxide film, or an indium gallium tin oxide film.

9. The electronic device according to claim 1, wherein the external circuit has an external electrode, and the conductive electrode is bonded to the external electrode by using a conductive adhesive.

10. The electronic device according to claim 9, wherein the conductive electrode is bonded to a side face of the external electrode by using a conductive adhesive;
or, the conductive electrode is bonded to a lower surface of the external electrode by using a conductive adhesive;
or, the conductive electrode is bonded to the external electrode by using a conductive adhesive and a wire.

## Patentansprüche

1. Elektronisches Gerät, das eine externe Schaltung umfasst, wobei das elektronische Gerät eine leitfähige Elektrode umfasst, wobei die leitfähige Elektrode Folgendes umfasst:
einen transparenten leitfähigen Film, der auf einem Substrat angeordnet ist;
eine haftende Zwischenschicht, die auf dem transparenten leitfähigen Film angeordnet ist, und
eine Metallschicht, die auf der haftenden Zwischenschicht angeordnet ist, wobei die Metallschicht hauptsächlich aus einem Edelmetall hergestellt ist und so ausgelegt ist, dass sie mit einer externen Schaltung verbunden wird;
wobei die leitfähige Elektrode ferner eine Schutzschicht umfasst und die Schutzschicht an einem Rand der haftenden Zwischenschicht angeordnet ist oder die Schutzschicht an Rändern von sowohl der haftenden Zwischenschicht als auch der Metallschicht angeordnet ist;
wobei die Metallschicht mittels Kleben mit der externen Schaltung verbunden ist.

2. Elektronisches Gerät nach Anspruch 1, wobei ein Rand der ersten haftenden Zwischenschicht mit einer Schutzschicht versehen ist.

3. Elektronisches Gerät nach Anspruch 1 oder 2, wobei die Schutzschicht hauptsächlich aus einer siliziumhaltigen Verbindung, einer aluminiumhaltigen Verbindung und/oder einer magnesiumhaltigen Verbindung hergestellt ist und vorzugsweise hauptsächlich aus SiO₂, SiN und/oder Al₂O₃ hergestellt ist.

4. Elektronisches Gerät nach Anspruch 1 oder 2, wobei eine Dicke der Schutzschicht größer ist als die der haftenden Zwischenschicht;
oder die Dicke der Schutzschicht größer ist als die Summe aus der Dicke der haftenden Zwischenschicht und einer Dicke der Metallschicht.

5. Elektronisches Gerät nach Anspruch 1, wobei die Dicke der haftenden Zwischenschicht 50 bis 100 nm beträgt.

6. Elektronisches Gerät nach Anspruch 1, wobei die Dicke der Metallschicht von 75 bis 300 nm beträgt.

7. Elektronisches Gerät nach Anspruch 1, wobei ein Verfahren zum Herstellen der haftenden Zwischenschicht Abscheiden umfasst und vorzugsweise ein Magnetronsputterverfahren ist;
und/oder ein Verfahren zum Herstellen der Metallschicht Abscheiden umfasst und vorzugsweise ein Magnetronsputterverfahren ist.

8. Elektronikgerät nach Anspruch 1, wobei der transparente leitfähige Film einen Indiumzinnoxidfilm, einen Indiumzinkoxidfilm, einen Indiumzinkzinnoxidfilm, einen Indiumaluminiumzinkoxidfilm, einen Indiumgalliumzinkoxidfilm und/oder einen Indiumgalliumzinnoxidfilm umfasst.

9. Elektronikgerät nach Anspruch 1, wobei die externe Schaltung eine externe Elektrode aufweist und die leitfähige Elektrode unter Verwendung eines leitfähigen Klebstoffs mit der externen Elektrode verbunden ist.

10. Elektronikgerät nach Anspruch 9, wobei die leitfähige Elektrode unter Verwendung eines leitfähigen Klebstoffs mit einer Seitenfläche der externen Elektrode verbunden ist;
oder die leitfähige Elektrode unter Verwendung eines leitfähigen Klebstoffs mit einer unteren Fläche der externen Elektrode verbunden ist;
oder die leitfähige Elektrode mit der externen Elektrode unter Verwendung eines leitfähigen Klebstoffs und eines Drahts verbunden ist.

## Revendications

1. Dispositif électronique, comprenant un circuit externe, le dispositif électronique comprenant une électrode conductrice, l'électrode conductrice comprenant :
un film conducteur transparent disposé sur un substrat ;
une couche adhésive intermédiaire disposée sur le film conducteur transparent ; et
une couche métallique disposée sur la couche adhésive intermédiaire, la couche métallique étant principalement formée par un métal précieux et configurée pour être collée à un circuit externe ;
dans lequel l'électrode conductrice comprend en outre une couche protectrice, et la couche protectrice est disposée sur un bord de la couche adhésive intermédiaire, ou la couche protectrice est disposée sur des bords à la fois de la couche adhésive intermédiaire et de la couche métallique ;
dans lequel la couche métallique est reliée au circuit externe par collage.

2. Dispositif électronique selon la revendication 1, dans lequel un bord de la première couche adhésive intermédiaire est pourvu d'une couche protectrice.

3. Dispositif électronique selon la revendication 1 ou 2, dans lequel la couche protectrice est principalement formée par au moins un composé parmi un composé contenant du silicium, un composé contenant de l'aluminium et un composé contenant du magnésium, et est de préférence principalement formée par au moins un composé parmi SiO₂, SiN et Al₂O₃.

4. Dispositif électronique selon la revendication 1 ou 2, dans lequel une épaisseur de la couche protectrice est supérieure à celle de la couche adhésive intermédiaire ;
ou l'épaisseur de la couche protectrice est supérieure à la somme de l'épaisseur de la couche adhésive intermédiaire et d'une épaisseur de la couche métallique.

5. Dispositif électronique selon la revendication 1, dans lequel l'épaisseur de la couche adhésive intermédiaire est de 50-100 nm.

6. Dispositif électronique selon la revendication 1, dans lequel l'épaisseur de la couche métallique est de 75-300 nm.

7. Dispositif électronique selon la revendication 1, dans lequel un procédé pour former la couche adhésive intermédiaire comprend un dépôt, et est de préférence un procédé de pulvérisation magnétron ;
et/ou un procédé pour former la couche métallique comprend un dépôt, et est de préférence un procédé de pulvérisation magnétron.

8. Dispositif électronique selon la revendication 1, dans lequel le film conducteur transparent en comprend au moins un parmi un film d'oxyde d'indium et d'étain, un film d'oxyde d'indium et de zinc, un film d'oxyde d'indium-zinc-étain, un film d'oxyde d'indium-aluminium-zinc, un film d'oxyde d'indium-gallium-zinc, et un film d'oxyde d'indium-gallium-étain.

9. Dispositif électronique selon la revendication 1, dans lequel le circuit externe a une électrode externe, et l'électrode conductrice est collée à l'électrode externe au moyen d'un adhésif conducteur.

10. Dispositif électronique selon la revendication 9, dans lequel l'électrode conductrice est collée à une face latérale de l'électrode externe au moyen d'un adhésif conducteur ;
ou l'électrode conductrice est collée à une surface inférieure de l'électrode externe au moyen d'un adhésif conducteur ;
ou l'électrode conductrice est collée à l'électrode externe au moyen d'un adhésif conducteur et d'un fil.
